(19) Europäisches Patentamt
European Patent Office
Office européen des brevets

(11) Veröffentlichungsnummer: **0 423 528 B1**

(12) # EUROPÄISCHE PATENTSCHRIFT

(45) Veröffentlichungstag der Patentschrift :
**19.01.94 Patentblatt 94/03**

(51) Int. Cl.[5]: **H01S 3/103**, H01S 3/085,
H01S 3/0933, H01L 33/00

(21) Anmeldenummer : **90118794.8**

(22) Anmeldetag : **01.10.90**

(54) **Elektrisch wellenlängenabstimmbarer Halbleiterlaser.**

(30) Priorität : **20.10.89 DE 3934998**

(43) Veröffentlichungstag der Anmeldung :
**24.04.91 Patentblatt 91/17**

(45) Bekanntmachung des Hinweises auf die
Patenterteilung :
**19.01.94 Patentblatt 94/03**

(84) Benannte Vertragsstaaten :
**DE FR GB IT NL**

(56) Entgegenhaltungen :
**EP-A- 0 314 490**
**IBM TECHNICAL DISCLOSURE BULLETIN,**
**Band 17, Nr. 10, März 1975, Seiten 3070-3072;**
**G. FARMER et al.: "Integrated LED pumped**
**corrugated GaAs distributive feedback laser"**
**PATENT ABSTRACTS OF JAPAN, Band 13, Nr.**
**16 (E-703)[3364], 13. Januar 1989 &**
**JP-A-63-222 487**
**ELECTRONICS LETTERS, Band 24, Nr. 8, April**
**1988, Seiten 503-505, Stevenage, Herts, GB; Y.**
**KOTAKI et al.: "Tunable DBR laser with wide**
**tuning range"**

(73) Patentinhaber : **Alcatel SEL**
**Aktiengesellschaft**
**Lorenzstrasse 10**
**D-70435 Stuttgart (DE)**
(84) **DE**
Patentinhaber : **ALCATEL N.V.**
**Strawinskylaan 341, (World Trade Center)**
**NL-1077 XX Amsterdam (NL)**
(84) **FR GB IT NL**

(72) Erfinder : **Schilling, Michael**
**Rastatter Strasse 38**
**D-7000 Stuttgart 31 (DE)**
Erfinder : **Wünstel, Klaus, Dr.**
**Stiegelstrasse 18**
**D-7141 Schwieberdingen (DE)**
Erfinder : **Dütting, Kaspar**
**Mähdachstrasse 38**
**D-7000 Stuttgart 31 (DE)**
Erfinder : **Schweizer, Heinz, Dr.**
**Niersteiner Strasse 18**
**D-7000 Stuttgart 31 (DE)**

(74) Vertreter : **Pohl, Herbert, Dipl.-Ing et al**
**Alcatel SEL AG Patent- und Lizenzwesen**
**Postfach 30 09 29**
**D-70449 Stuttgart (DE)**

**Beschreibung**

Die Erfindung betrifft einen wellenlängenabstimmbaren Halbleiterlaser mit einem laseraktiven Bereich, einem abstimmbaren Frequenzfilter und einem Photonenemissionsbereich, aus dem Photonen in den laseraktiven Bereich injiziert werden.

Aus Electronics Letters 24, No. 8, S. 503-505 ist ein derartiger Halbleiterlaser bekannt. Er besteht aus drei longitudinal, d.h. in Längsrichtung nebeneinander, integrierten Bereichen: einem laseraktiven Bereich zur Lichtverstärkung, einem regelbaren Phasenschieberbereich und einem verteilten Bragg-Reflektor, der das abstimmbare Frequenzfilter bildet. Er ist seitlich des laseraktiven Bereichs angeordnet, und durch ihn wird die Bragg-Wellenlänge des Wellenleiterbereichs bestimmt. Ein derartiger Halbleiterlaser wird auch als Multisegmentlaser bezeichnet. Um die Wellenlänge des Laserlichtes durchzustimmen, werden in den Phasenschieberbereich und den Wellenleiterbereich im Gebiet des Bragg-Gitters Ströme injiziert; letzterer ändert die Bragg-Wellenlänge, weil sich der Brechungsindex in diesem Bereich durch den Plasmaeffekt und den Bandauffüllefekt ändert.

Aus dem InP-Workshop, Heinrich-Hertz-Institut, Berlin, 8.-9.5.1989, ist eine "kontinuierlich abstimmbare Lasertriode" bekannt; dieser Halbleiterlaser ist transversal integriert.

Zur Abstimmung seines effektiven Brechungsindex ist nur ein einziger Steuerstrom erforderlich. Um die Absorption von Photonen aus dem Bereich des Bragg-Gitters zu vermindern, ist dieser Bereich aus einem Material hergestellt, das gegenüber dem laseraktiven Bereich eine höhere Bandkante aufweist. Dadurch wird aber die Wirkung der Ladungsträgerinjektion im laseraktiven Bereich vermindert, da der Plasmaeffekt gerade in der Nähe der Bandkante des Halbleitermaterials sein Maximum erreicht. Auch durch die Variation der Bandmassen von Elektronen und Löchern im Bereich des Bragg-Gitters lassen sich nicht erheblich mehr Photonen in den laseraktiven Bereich injizieren. Allein die stimulierte Emission von Photonen im Bereich des Bragg-Gitters wird unterdrückt.

Es ist daher die Aufgabe der Erfindung, einen Halbleiterlaser zu schaffen, in dessen laseraktiven Bereich wirkungsvoller Photonen injiziert werden, und der einen großen, kontinuierlich durchstimmbaren Wellenlängenbereich und eine hohe Lichtausgangsleistung aufweist.

Die Aufgabe wird dadurch gelöst, daß aus dem Photonenemissionsbereich solche Photonen in den laseraktiven Bereich injiziert werden, deren Energien die Energie-Summe aus dem chemischen Potential der Elektron-Loch-Paare und der Energie der longitudinalen akustischen Phononen in dem laseraktiven Bereich um weniger als die halbe thermische Energie übertreffen.

Vorteilhafte Weiterbildungen ergeben sich aus den Unteransprüchen.

Aus dem Anspruch 8 ist ein Verfahren zum Herstellen eines erfindungsgemäßen Halbleiterlasers zu entnehmen.

Ein Ausführungsbeispiel der Erfindung wird nachstehend anhand der Zeichnung erläutert. Es zeigen:

Fig.1    ein Schema der Bandstruktur in dem aktiven Laserbereich;

Fig.2    den Aufbau eines wellenlängenabstimmbaren Halbleiterlasers;

Fig.3a-3f    den Aufbau eines zweiten wellenlängenabstimmbaren Halbleiterlasers.

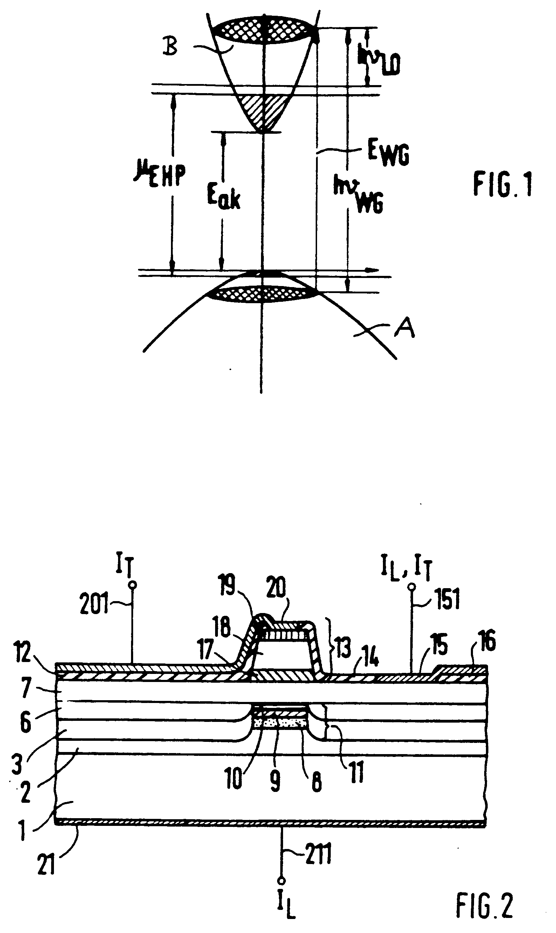

Valenzband A und Leitungsband B (Fig.1) im laseraktiven Bereich eines Halbleiterlasers haben ihre Bandkante an derselben Stelle in der Brillouin-Zone, wenn der laseraktive Bereich aus einem direkten Halbleitermaterial besteht.

Der Bandabstand an dieser Stelle entspricht einer Bandabstandsenergie $E_{ak}$. Die Differenz der chemischen Potentiale der Elektronen im Leitungsband B und der Löcher im Valenzband A, d.h. das chemische Potential des Elektron-Loch-Plasmas, ist mit $u_{EHP}$ bezeichnet. Aufgrund der Fermi-Verteilung weist die Zustandsdichte der Elektronen eine "Verschmierung" auf, die sich durch das Produkt aus der Boltzmann-Konstanten $k_B$ und der Temperatur T, $k_B * T$, ausdrücken läßt.

Wenn nun Photonen mit einer Energie $h\nu_{WG}$ aus dem Photonenemissionsbereich des Halbleiterlasers in den laseraktiven Bereich injiziert werden, dann können sie jeweils ein Elektron aus dem "Fermi-See" des Valenzbandes A in das Leitungsband B anheben. Dabei wird ein Phonon der longitudinal-optischen Mode (LO) mit der Energie $h\nu_{LO}$ gestreut, wenn das durch die Photoneninjektion erzeugte Elektron mindestens um den Energiebetrag des Phonons oberhalb des chemischen Potentials des Elektron-Loch-Plasmas (EHP) im laseraktiven Bereich liegt. Um diesen Prozeß zu verhindern, gilt für die Bandkantenenergie des Wellenleiterbereiches, $E_{WG} = h\nu_{WG}$, daß sie nur weniger als die Energie $h\nu_{LO}$ des Phonons größer sein darf, bezogen auf das chemische Potential $u_{EHP}$.

$$E_{WG} \leqq \mu_{EHP} + h\nu_{LO} \pm \frac{k_B T}{2}$$

Der Term $\frac{k_B * T}{2}$ in der Ungleichung gibt die Schwankungsbreite an, die durch die Fermiverteilung bei der Temperatur T gegeben ist.

Dadurch gelangen Elektronen im laseraktiven Bereich in eine energetische Lage, aus der sie nur mit einer geringen Häufigkeit durch akustische Phononen zu niedrigeren Energien gestreut werden können. Insbesondere tragen solche Elektronen nicht zur stimulierten Emission bei. Dadurch gelingt es, lokal in dem laseraktiven Bereich die Elektronendichte N über die Laser-Schwelldichte hinaus zu erhöhen. Die über die Schwelldichte hinausgehende Dichte N erlaubt eine Veränderung der Dielektrizitätskonstanten gemäß der Dichteabhängigkeit der Dielektrizitätskonstanten. Aufgrund des Zusammenhangs der Änderung der Bragg-Wellenlänge $\Lambda$ mit der Änderung der Dielektrizitätskonstanten und der Beziehung zwischen der Änderung der Dielektrizitätskonstanten mit der Änderung der Elektronendichte N

$$\frac{\Delta\Lambda}{\Lambda} = \frac{\Delta n}{n} = \frac{\Delta N}{N}$$

läßt sich die Emissionswellenlänge des Halbleiterlasers durchstimmen. Dabei bedeutet n den Brechungsindex.

Eine Schicht 9 (Fig.2) und eine den Photonenemissionsbereich bildende Schicht 17, die diese Bedingungen erfüllen, sind Teil eines in Transversalrichtung, d.h. im Querschnitt gezeigten Halbleiterlasers. Die Schichten 9 und 17 können sowohl senkrecht zueinander als auch nebeneinander liegen. Der Halbleiterlaser ist auf einem Halbleitersubstrat 1, hier: einem p-InP-Substrat, hergestellt.

Auf der Unterseite des Halbleitersubstrats 1 befindet sich eine dünne Metallschicht 21 mit einem elektrischen Kontakt 211. Oberhalb des p-InP-Substrats befindet sich eine weitere p-InP-Schicht 2, die in der Mitte nach oben hin eine Verdickung aufweist und den unteren Teil einer Mesa 11 bildet. Die p-InP-Schicht 2 dient als Pufferschicht. Sie weist auf ihrer Oberseite ein abstimmbares Bragg-Gitter auf, das als Frequenzfilter wirkt.

Oberhalb von ihr enthält die Mesa 11 eine Schicht 8 aus einer quaternären Halbleiterverbindung, hier: aus p-InGaAsP, die einen Wellenleiterbereich bildet, und die Schicht 9, die ebenfalls aus einer quaternären Halbleiterverbindung, hier: aus InGaAsP, besteht und den laseraktiven Bereich darstellt. Dabei hat die Schicht 8 einen größeren Bandabstand zwischen Valenz- und Leitungsband als die Schicht 9.

Anstelle eines einzigen Wellenleiterbereichs und einer einzigen laseraktiven Zone können auch Quantum-Well-Schichten vorhanden sein. Oberhalb der Schicht 9 bildet eine InP-Schicht 10 die oberste Schicht der Mesa 11. Auf beiden Seiten der Mesa 11 liegt eine semiisolierende Schicht 6 aus InP, die bis zur Höhe der Mesa 11 reicht. Oberhalb des Mesa 11 und der InP-Schicht 6 liegt eine sich über den ganzen Querschnitt des Halbleiterlasers erstreckende Schicht 7 aus n-InP, die von einer dielektrischen Schicht 12 aus $SiO_2$, oberhalb der Mesa 11 von einer Mesa 13, einer weiteren dielektrischen Schicht 14 aus $SiO_2$, einer Metallschicht 15 und einer dritten dielektrischen Schicht 16 aus $SiO_2$ bedeckt ist. An die Stelle von $SiO_2$ kann auch ein anderes dielektrisches Material treten.

Die Mesa 13 setzt sich zusammen aus einer InGaAsP-Schicht, die den Photonenemissionsbereich 17 bildet, einer p-InP-Schicht 18, die als Mantelschicht dient, und einer $p^+$-InGaAs- oder $p^+$-InGaAsP-Schicht 19, die als Kontaktschicht dient. Oberhalb von ihr ist wiederum eine Metallschicht 20 vorhanden, die seitlich auch noch die Schicht 12 überzieht und einen elektrischen Kontakt 201 aufweist.

Die Metallschicht 15 hat einen Kontakt 151. Über die Kontakte 151, 201 fließt ein Strom $I_T$ zur Abstimmung der Photoneninjektion aus dem Photonenemissionsbereich 17. Der Kontakt 151 dient gleichzeitig, zusammen mit dem Kontakt 211, zur Aufnahme des Laser-Steuerstromes $I_L$.

In einem anderen, hier nicht dargestellten Ausführungsbeispiel weist die Schicht 7 auf ihrer Oberseite oberhalb der Mesa 11 ebenfalls ein Bragg-Gitter auf. Dieses ist ein Gitter höherer Ordnung, während das Bragg-Gitter auf der Schicht 2 ein Gitter 1. Ordnung ist. In diesem Fall weist der Halbleiterlaser zwei Wellenleiterschichten auf.

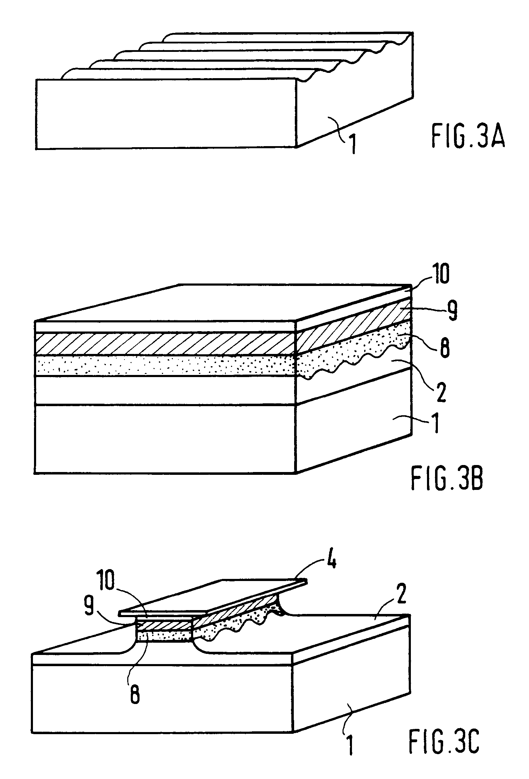

Der Halbleiterlaser (Fig. 2) läßt sich herstellen, indem entweder unmittelbar auf dem Halbleiter-Substrat 1 (Fig. 3a) ein Beugungsgitter geätzt wird, oder auf das Halbleitersubstrat 1 zunächst die p-InP-Schicht 2 als Pufferschicht epitaktisch aufgebracht wird und dann auf dieser das Bragg-Gitter geätzt wird (Fig. 3b).

Anschließend werden epitaktisch die Schichten 8, 9 und 10 abgeschieden. Über der Schicht 10 wird eine Schicht 4 aus einem Dielektrikum, z.B. $SiO_2/Si_3N_4$, aufgebracht, die im Lithographieprozeß bis einen schmalen, ca. 2 um breiten Streifen entfernt wird, so daß seitlich von ihm durch vollständiges Abätzen der Schichten 8, 9, 10 und teilweises Abätzen der p-InP-Schicht 2 bzw. des Halbleitersubstrates 1 (vgl. Fig 3a) selbst die Mesa 11 (Fig. 3c) hergestellt wird.

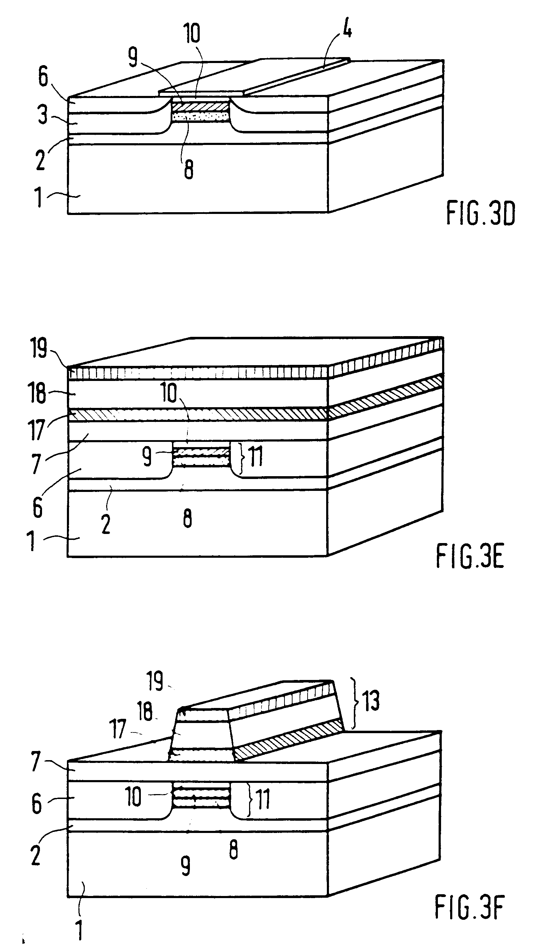

Darauf wird mittels selektiver Epitaxie die Schicht 6 (Fig. 3d) als stromblockierender Seitenbereich abgeschieden. Die $SiO_2/SiO_3N_4$-Schicht 4 wird dann entfernt (Fig. 3e), epitaktisch werden die Schicht 7, der Photonenemissionsbereich 17, sowie die Schichten 17, 18 abgeschieden.

Nach erneuter lithographischer Strukturierung (vgl. Fig 3c) wird die Mesa 13 durch selektives Abätzen des Photonenemissionsbereichs 17, der p-InP-Schicht 18 und der $p^+$-InGaAs- oder $p^+$-InGaAsP-Schicht 19 erzeugt (Fig. 3f).

Die Mesa 13 sowie die n-InP-Schicht 7 zu beiden Seiten der Mesa 13 werden mit einer $SiO_2$-Schicht überzogen. Oberhalb der Mesa 13 und an einer Stelle seitlich der Mesa 13 wird sie weggeätzt. Dadurch entstehen die Schichten 12, 14, 16. Dann werden drei Metallschichten 15, 20 und 21 aufgebracht, von denen die beiden ersten die weggeätzten Stellen bedecken und die Metallschicht 21 des Substrat 1 von unten bedeckt. Jede der drei Metallschichten 15, 20, 21 wird mit einem elektrischen Kontakt 151, 201, 211 versehen (vgl. Fig. 2).

## Patentansprüche

1. Elektrisch wellenlängenabstimmbarer Halbleiterlaser mit einem laseraktiven Bereich (9), einem abstimmbaren Frequenzfilter und einem Photonenemissionsbereich (17), aus dem Photonen in den laseraktiven Bereich injiziert werden,
   **dadurch gekennzeichnet,**
   daß aus dem Photonenemissionsbereich (17) solche Photonen in den laseraktiven Bereich injiziert werden, deren Energien die Energie-Summe aus dem chemischen Potential von Elektron-Loch-Paaren und der Energie longitudinaler akustischer Phononen in dem laseraktiven Bereich um weniger als die halbe thermische Energie übertreffen.

2. Halbleiterlaser nach Anspruch 1,
   dadurch gekennzeichnet,
   daß ein Strom ($I_T$) zur Abstimmung der Photoneninjektion aus dem Photonenemissionsbereich (17) in den laseraktiven Bereich durch den Photonenemissionsbereich fließt.

3. Halbleiterlaser nach Anspruch 1,
   dadurch gekennzeichnet,
   - daß das Frequenzfilter ein erstes Bragg-Gitter ist und
   - daß der Photonenemissionsbereich (17) in derselben Ebene wie der laseraktive Bereich, oberhalb oder unterhalb von diesem angeordnet und mit einem zweiten Bragg-Gitter räumlich verbunden ist.

4. Halbleiterlaser nach Anspruch 3,
   dadurch gekennzeichnet,
   daß der Photonenemissionsbereich (17) als Wellenleiterzone ausgebildet ist.

5. Halbleiterlaser nach Anspruch 1,
   dadurch gekennzeichnet,
   daß der Photonenemissionsbereich aus einer III-V-Halbleiterverbindung besteht.

6. Halbleiterlaser nach Anspruch 3,
   dadurch gekennzeichnet,
   daß das zweite Bragg-Gitter ein Gitter höherer Ordnung ist.

7. Halbleiterlaser nach Anspruch 6, dadurch gekennzeichnet,
   daß sein laseraktiver Bereich aus einer quaternären Halbleiter-Verbindung besteht.

8. Halbleiterlaser nach Anspruch 7, dadurch gekennzeichnet,
   - daß er aus mehreren übereinanderliegenden Schichten besteht:
     einer ersten Metallschicht (21) mit einem ersten elektrischen Kontakt (211), einem Halbleitersubstrat (1), einer ersten p-leitenden Indiumphosphid-Schicht (2), die auf ihrer Oberseite das erste Bragg-Gitter aufweist, einer aus p-leitendem Indium-Galliumarsenid-Phosphid bestehenden Schicht (8), einer Schicht (9) aus Indium-Galliumarsenid-Phosphid, die den laseraktiven Bereich bildet, einer Indiumphosphid-Schicht (10),
   - daß diese drei Schichten (8,9,10) zusammen mit der unter ihnen verdickten, p-leitenden Indiumphosphid-Schicht (2) eine erste, vergrabene Mesa (11) bilden,
   - daß sich seitlich der Mesa (11) oberhalb der p-leitenden Indiumphosphid-Schicht (2) eine semiisolierende Schicht (6) befindet,
   - daß auf der Mesa (11) und der semiisolierenden Schicht (6) eine Schicht (7) aus n-leitendem Indiumphosphid liegt,
   - - daß auf dieser in Transversalrichtung nebeneinander eine erste dielektrische Schicht (12), eine zweite Mesa (13), eine zweite dielektrische Schicht (14), eine zweite Metallschicht (15) mit einem zweiten elektrischen Kontakt (151) und eine dritte dielektrische Schicht (16) liegen,
- daß die zweite Mesa (13) aus einem aus Indium-Galliumarsenid-Phosphid bestehenden Photonenemissionsbereich (17), einer zweiten p-leitenden Indiumphosphid-Schicht (18) und einer p$^+$-leitenden Indium-Galliumarsenid-Schicht oder einer p$^+$-leitenden Indium-Galliumarsenid-Phosphid-Schicht (19) besteht, oberhalb von einer dritten Metallschicht (20) und seitlich von den Siliziumdioxid-Schichten (12,14) bedeckt ist und
- daß die dritte Metallschicht (20) mit einem dritten elektrischen Kontakt (201) versehen ist.

9.  Verfahren zum Herstellen eines Halbleiterlasers nach Anspruch 8, dadurch gekennzeichnet,
- daß auf dem p-leitendem Indiumphosphid-Substrat (1) epitaktisch die erste p-leitende Indiumphosphid-Schicht (2) hergestellt und auf ihr ein Beugungsgitter geätzt wird,
- daß darauf epitaktisch die Schicht (8) aus p-leitendem Indium-Galliumarsenid-Phosphid, die aus Indium-Galliumarsenid-Phosphid bestehende Schicht (9) und die Indiumphosphid-Schicht (10) aufgebracht werden,
- daß über der Indiumphosphid-Schicht (10) eine Schicht (4) aus einem Dielektrikum aufgebracht und bis auf einen in longitudinaler Richtung auf der Mitte der Indiumphosphid-Schicht (10) verlaufenden Streifen entfernt wird,
- daß die p-leitende-Indium-Galliumarsenid-Phosphid-Schicht (8), die Indium-Galliumarsenid-Phosphid-Schicht (9) und die Indiumphosphid-Schicht (10) bis auf den durch die Schicht (4) definierten Streifen ganz und die erste p-leitende Indiumphosphid-Schicht (2) teilweise abgeätzt werden und dadurch die erste Mesa (11) hergestellt wird,
- daß zu beiden Seiten der ersten Mesa (11) auf der ersten p-leitenden Indiumphosphid-Schicht (2) die Schicht aus semiisolierendem Indiumphosphid (6) aufgebracht wird,
- daß darauf die Siliziumdioxid-/Siliziumnitrid-Schicht (4) entfernt und epitaktisch auf der ersten Mesa (11) und der Schicht aus semiisolierendem Indiumphosphid (6) die n-leitende Indiumphosphid-Schicht (7), der Photonenemissionsbereich (17), die zweite p-leitende Indiumphosphid-Schicht (18) und die p$^+$-leitende Indium-Galliumarsenid-Schicht (19) oder die Indium-Galliumarsenid-Phosphid-Schicht (19) abgeschieden werden,
- daß oberhalb der ersten Mesa (11) die zweite Mesa (13) durch teilweises Abätzen der Indium-Galliumarsenid-Phosphid-Abstimmschicht (17), der p-leitenden Indiumphosphid-Photonenemissionsschicht (18) und der p$^+$-leitenden Indium-Galliumarsenid-Schicht (19) oder der Indium-Galliumarsenid-Phosphid-Schicht (19) entsteht,
- daß die zweite Mesa (13) und die n-leitende Indiumphosphid-Schicht (7) beiderseits der zweiten Mesa (13) mit der dielektrischen Schicht überzogen werden,
- daß diese dann oberhalb und an einer Stelle seitlich der zweiten Mesa (13) abgeätzt wird, so daß die erste, zweite und dritte dielektrische Schicht (12, 14, 16) entsteht,
- daß auf diese beiden Stellen und auf dem p-leitenden Indiumphosphid-Substrat (1) die Metallschichten (15,20,21) aufgebracht werden, deren jede mit einem elektrischen Kontakt (151,201,211) versehen wird.

## Claims

1.  An electrically wavelength tunable semiconductor laser including a laser-active region (9), a tunable frequency filter and a photon emission region (17) from which photons are injected into the laser-active region, characterised in that the photons injected into the laser-active region from the photon emission region (17) are those whose energy exceeds the sum of the energy of the chemical potential of electron-hole pairs and the energy of longitudinal acoustic phonons in the laser-active region by less than one-half the thermal energy.

2.  A semiconductor laser according to claim 1, characterised in that a current ($I_T$) for tuning the photon injection flows from the photon emission region (17) through the photon emission region into the laser-active region.

3.  A semiconductor laser according to claim 1, characterised in that
- the frequency filter is a first Bragg grating; and
- the photon emission region (17) is disposed in the same plane as the laser-active region, above or below said laser-active region and is spatially connected with a second Bragg grating.

4. A semiconductor laser according to claim 3, characterised in that the photon emission region (17) is configured as a waveguide zone.

5. A semiconductor laser according to claim 1, characterised in that the photon emission region is composed of a III-V semiconductor compound.

6. A semiconductor laser according to claim 3, characterised in that the second Bragg grating is a higher order grating.

7. A semiconductor laser according to claim 6, characterised in that its laser-active region is composed of a quaternary semiconductor compound.

8. A semiconductor laser according to claim 7, characterised in that
   - it is composed of a plurality of superposed layers: a first metal layer (21) provided with a first electrical contact (211), a semiconductor substrate (1), a first p-conductive indium phosphide layer (2) provided on its top face with the first Bragg grating, a layer (8) composed of p-conductive indium gallium arsenide phosphide, a layer (9) of indium gallium arsenide phosphide forming the laser-active region, an indium phosphide layer (10);
   - these three layers (8, 9, 10) together with the p-conductive indium phosphide layer (2) which has been thickened underneath them form a first, buried mesa (11);
   - a semi-insulating layer (6) is disposed to the side of the mesa (11) above the p-conductive indium phosphide layer (2);
   - a layer (7) of n-conductive indium phosphide is disposed on the mesa (11) and on the semi-insulating layer (6);
   - a first dielectric layer (12), a second mesa (13), a second dielectric layer (14), a second metal layer (15) provided with a second electrical contact (151) and a third dielectric layer (16) lie next to one another in the transversal direction on the n-conductive indium phosphide layer;
   - the second mesa (13) is composed of a photon emission region (17) of indium gallium arsenide phosphide, a second p-conductive indium phosphide layer (18) and a $p^+$-conductive indium gallium arsenide layer or a $p^+$-conductive indium gallium arsenide phosphide layer (19) and is covered on the top by a third metal layer (20) and on the sides by the silicon dioxide layers (12, 14); and
   - the third metal layer (20) is provided with a third electrical contact (201).

9. A method of producing a semiconductor laser according to claim 8, characterised in that
   - the first p-conductive indium phosphide layer (2) is produced epitaxially on the p-conductive indium phosphide substrate (1) and a diffraction grating is etched on it;
   - the layer (8) of p-conductive indium gallium arsenide phosphide, the layer (9) of indium gallium arsenide phosphide and the indium phosphide layer (10) are applied epitaxially thereto;
   - a layer (4) of a dielectric material is applied over the indium phosphide layer (10) and is removed except for a strip extending longitudinally over the centre of the indium phosphide layer (10);
   - the p-conductive indium gallium arsenide phosphide layer (8), the indium gallium arsenide phosphide layer (9) and the indium phosphide layer (10) are etched away completely except for the strip defined by layer (4) and the first p-conductive indium phosphide layer (2) is etched away in part thus producing the first mesa (11);
   - the layer of semi-insulating indium phosphide (6) is applied on both sides of the first mesa (11) onto the first p-conductive indium phosphide layer (2);
   - thereafter, the silicon dioxide/silicon nitride layer (4) is removed and the n-conductive indium phosphide layer (7), the photon emission region (17), the second p-conductive indium phosphide layer (18) and the $p^+$-conductive indium gallium arsenide layer (19) or the indium gallium arsenide phosphide layer (19) are precipitated epitaxially onto the first mesa (11) and onto the layer of semi-insulating indium phosphide (6);
   - above the first mesa (11), the second mesa (13) is produced by partially etching away the indium gallium arsenide phosphide tuning layer (17), the p-conductive indium phosphide photon emission layer (18) and the $p^+$-conductive indium gallium arsenide layer (19) or the indium gallium arsenide phosphide layer (19);
   - the second mesa (13) and the n-conductive indium phosphide layer (7) are covered with the dielectric layer on both sides of the second mesa (13);

- whereupon the dielectric layer is etched away above and at a location to the side of the second mesa (13) so that the first, second and third dielectric layers (12, 14, 16) are created;
- the metal layers (15, 20, 21) are then applied onto these two locations and onto the p-conductive indium phosphide substrate (1) and are each provided with an electrical contact (151, 201, 211).

## Revendications

1. Laser à semi-conducteur à longueur d'onde accordable électriquement, comportant une zone (9) à activité laser, un filtre de fréquence accordable et une zone (17) d'émission de photons à partir de laquelle des photons sont injectés dans la zone à activité laser,
   laser caractérisé
   par le fait qu'à partir de la zone (17) d'émission des photons sont injectés dans la zone à activité laser des photons dont l'énergie surpasse, de moins que la demi-énergie thermique, la somme énergétique constituée du potentiel chimique des paires électron -trou et de l'énergie des phonons de la branche acoustique longitudinale de la zone à activité laser.

2. Laser à semi-conducteur selon la revendication 1,
   caractérisé
   par le fait que, pour réaliser l'accord de l'injection de photons, depuis la zone (17) d'émission des photons, dans la zone à activité laser, un courant ($I_T$) passe à travers la zone d'émission des photons.

3. Laser à semi-conducteur selon la revendication 1,
   caractérisé
   - par le fait que le filtre de fréquence est une première grille de Bragg et
   - par le fait que la zone (17) d'émission des photons est disposée dans le même plan que la zone à activité laser, au-dessus ou au-dessous de celle-ci et qu'elle est reliée spatialement avec une seconde grille de Bragg.

4. Laser à semi-conducteur selon la revendication 3,
   caractérisé
   par le fait que la zone (17) d'émission des photons est conçue en tant que zone guide d'ondes.

5. Laser à semi-conducteur selon la revendication 1,
   caractérisé
   par le fait que la zone d'émission des photons est constituée d'une jonction semi-conductrice III-V.

6. Laser à semi-conducteur selon la revendication 3,
   caractérisé
   par le fait que la seconde grille de Bragg est une grille d'ordre plus élevé.

7. Laser à semi-conducteur selon la revendication 6,
   caractérisé
   par le fait que sa zone à activité laser est constituée d'une jonction semi-conductrice quaternaire.

8. Laser à semi-conducteur selon la revendication 7,
   caractérisé
   - par le fait qu'il est consitué de plusieurs couches superposées:
     une première couche métallique (21) comprenant un premier contact électrique (211), un substrat semi-conducteur (1), une première couche de phosphure d'indium de conductibilité de type n (2), qui présente sur sa face supérieure la première grille de Bragg, une couche (8) constituée de phosphure-arséniure d'indium-gallium, une couche (9) constituée de phosphure arséniure d'indium-gallium qui forme la zone à activité laser, une couche de phosphure d'indium (10),
   - par le fait que ces trois couches (8,9,10) forment, avec la couche de phosphure d'indium (2) de conductibilité de type p, épaissie sous elles, une première structure mésa enfouie (11),
   - par le fait qu'à côté de la structure mésa (11), au-dessus de la couche de phosphure d'indium (2) de conductibilité de type p se trouve une couche semi-isolante (6),
   - par le fait que sur la structure mésa (11) et sur la couche semi-isolante (6) se trouve une couche (7) de phosphure d'indium de conductibilité de type n,

- par le fait que sur celle-ci se trouvent, l'une à côté de l'autre selon la direction transversale, une première couche diélectrique (12), et une seconde structure mésa (13), une seconde couche diélectrique (14), une seconde couche métallique (15) avec un second contact électrique (151) et une troisième couche diélectrique (16),
- par le fait que la seconde structure mésa (13) est constituée d'une zone (17) d'émission de photons elle-même constituée de phosphure arséniure d'indium-gallium d'une seconde couche (18) de phosphure d'indium de conductivité de type p et d'une couche d'arséniure d'indium-gallium de conductibilité de type p$^+$ ou d'une couche (19) de phosphure arséniure d'indium-gallium de conductibilité de type p$^+$, et qu'elle est recouverte, par-dessus, d'une troisième couche métallique (20) et, sur le côté, des couches (12,14) de dioxyde de silicium et
- par le fait que la troisième couche métallique (20) comporte un troisième contact électrique (201).

9. Procédé de fabrication d'un laser à semi-conducteur selon la revendication 8, caractérisé

- par le fait que sur le substrat (1) de phosphure d'indium de conductibilité de type p on fabrique par épitaxie la première couche de phosphore d'indium (2) de conductibilité de type p et qu'on y réalise, par attaque chimique, une grille de diffraction,
- que l'on rapporte par-dessus, par épitaxie, la couche (8) constituée de phosphure-arséniure d'indium-gallium de conductibilité de type p, la couche (9) constituée de phosphure arséniure d'indium-gallium et la couche de phosphure d'indium (10),
- par le fait que par-dessus la couche de phosphure d'indium (10) on rapporte une couche (4) constituée d'un diélectrique et qu'on l'élimine à l'exception d'un ruban passant, en direction longitudinale, sur le milieu de la couche de phosphure d'indium (10),
- par le fait que l'on élimine, par attaque chimique, complètement la couche (8) de phosphure arséniure d'indiumgallium de conductibilité de type p, la couche (9) de phospbure arséniure d'indium-gallium et la couche (10) de phosphure d'indium à l'exception du ruban défini par la couche (4) et partiellement la première couche (2) de phosphure d'indium de conductibilité de type p, et que de ce fait on réalise la première structure mésa (11),
- par le fait que des deux côtés de la première structure mésa (11), on rapporte, sur la première couche (2) de phosphure d'indium de conductibilité de type p, la couche de phosphure d'indium semi-isolant (6),
- par le fait qu'on élimine alors la couche (4) de dioxyde de silicium/niture de silicium et que, par épitaxie, on dépose sur la première structure mésa (11) et sur la couche de phosphure d'indium semi-isolant (6), la couche (7) de phosphure d'indium de conductibilité de type n, la zone (17) d'émission des photons, la seconde couche (18) de phosphure d'indium de conductibilité de type p et la couche (19) d'arséniure d'indium-gallium de conductibilité de type p$^+$ ou la couche (19) de phosphure arséniure d'indium-gallium,
- par le fait qu'au-dessus de la première structure mésa (11) on fasse apparaitre la seconde structure mésa (13) par attaque chimique partielle de la couche d'accord (17) de phosphure arséniure d'indium-gallium, de la couche (18) d'émission des photons de phosphure d'indium de conductibilité de type p et de la couche (19) d'arséniure d'indium-gallium de conductibilité de type p$^+$ ou de la couche (19) de phosphure arséniure d'indium-gallium,
- par le fait que l'on revêt de la couche diélectrique la seconde structure mésa (13) et la couche (7) de phosphure d'indium de conductibilité de type n se trouvant des deux côtés de la seconde structure mésa (13),
- par le fait que l'on élimine alors par attaque chimique cette couche diélectrique au-dessus et à un endroit sur le côté de la seconde structure mésa (13) de façon à faire apparaitre la première, la seconde et la troisième couches diélectriques (12, 14, 16),
- par le fait qu'en ces deux endroits et sur le substrat (1) de phosphure d'indium de conductibilité de type p, on rapporte des couches métalliques (15,20,21) dont chacune comporte un contact électrique (151,201,211).

FIG.1

FIG.2

FIG.3A

FIG.3B

FIG.3C

FIG.3D

FIG.3E

FIG.3F